# EUROPÄISCHE PATENTSCHRIFT

(11) **EP 1 692 925 B1**
(45) Veröffentlichungstag und Bekanntmachung des Hinweises auf die Patenterteilung: **05.03.2008**
(21) Anmeldenummer: 04786865.8
(22) Anmeldetag: 28.09.2004
(51) Int. Cl.: H05K 5/00, H05K 7/14, B60R 16/02

(54) **BAUELEMENT**
COMPONENT
ELEMENT DE CONSTRUCTION

(30) Priorität: 06.12.2003 DE 10357152
(43) Veröffentlichungstag der Anmeldung: 23.08.2006
(73) Patentinhaber: ROBERT BOSCH GMBH, 70442 Stuttgart (DE)
(72) Erfinder: SCHMICH, Franz, 72793 Pfullingen (DE); BETZ, Volker, 72537 Mehrstetten (DE); GRABMAIER, Florian, 72827 Wannweil (DE); KUNERT, Peter, 72805 Lichtenstein (DE)
(86) Internationale Anmeldenummer: PCT/DE2004/002150
(87) Internationale Veröffentlichungsnummer: WO 2005/057998

(56) Entgegenhaltungen:
- EP-A- 0 481 806
- EP-A- 0 540 071
- EP-A- 0 908 363
- US-B1- 6 400 044

## Beschreibung

### Stand der Technik

Die Erfindung geht aus von einem Bauelement mit einem Funktionsmodul und einem Gehäuse.

Beschleunigungen und Drehraten in Kraftfahrzeugen werden mit mikromechanischen Sensoren gemessen. Diese Sensoren enthalten eine seismische Masse und weitere bewegliche Strukturen sowie Messmittel, welche die Auslenkung der seismischen Masse unter dem Einfluss äußerer Beschleunigungen detektieren. Wird der mikromechanische Sensor durch Kraftwirkungen verspannt oder verformt, hat dies Auswirkungen auf die mikromechanischen Strukturen und es kann zu fehlerhaften Messsignalen kommen.

In einem Sensoraufbau nach Stand der Technik wird ein Sensormodul, bestehend aus einer Stahlgrundplatte mit aufgeklebter Hybridschaltung und aufgeschweißter Blechkappe direkt in ein Kunststoffgehäuse eingesetzt und großflächig verklebt. Das Kunststoffgehäuse besitzt Anschraubpunkte zum Verschrauben mit der Karosserie eines Kraftfahrzeuges. Wird das Kunststoffgehäuse beim Verschrauben verspannt, so kann nicht ausgeschlossen werden, dass sich z.B. bei einem darin montierten mikromechanischen Drehratensensor infolge der Torsion der Fehler des Signals erhöht.

Die US 6 400 044 B1 zeigt ein Bauelement mit einen Funktionsmodul, in dessen das Funktionsmodul federn gefestigt ist.

### Vorteile der Erfindung

Die Erfindung geht aus von einem Bauelement mit einem Funktionsmodul und einem Gehäuse. Der Kern der Erfindung liegt darin, dass an dem Gehäuse Befestigungsmittel zur Befestigung des Funktionsmoduls derart vorgesehen sind, dass das Funktionsmodul von Kraftwirkungen, die durch Verformungen des Gehäuses hervorgerufen werden, zumindest teilweise entkoppelt ist.

Das erfindungsgemäße Bauelement hat den Vorteil, dass das Funktionsmodul von verformenden Kraftwirkungen zumindest weitgehend entkoppelt wird. Dies ist besonders vorteilhaft bei Funktionsmodulen, deren Funktion durch mechanische Parameter bestimmt oder zumindest beeinflusst wird. Solche Funktionsmodule sind zum Beispiel mikromechanische Strukturen (MEMS), wie sie in Beschleunigungs- und Drehratensensoren verwendet werden. Bei den Funktionsmodulen kann es sich auch um Anordnungen optische Elemente handeln, die durch Verformungen, sowie Änderung der Geometrie oder Lage zueinander Veränderungen der optischen Eigenschaften zeigen.

Eine vorteilhafte Ausgestaltung des Bauelements besteht darin, dass die Befestigungsmittel zur Befestigung des Funktionsmoduls am Gehäuse eine Wegverlängerung für Krafteinwirkungen von dem Gehäuse auf das Funktionsmodul darstellen. Wird beispielsweise der obere Rand des Gehäuses verformt, so würde sich unmittelbar eine Kraftwirkung auf das Funktionsmodul ergeben, wenn es dort befestigt wäre. Gemäß der hier beschriebenen Ausgestaltung ist hingegen vorgesehen, Funktionsmodul und Gehäuse mittels der Befestigungsmittel derart zu verbinden, dass eine direkte Kraftwirkung vom Ort der Verformung des Gehäuses an das Funktionsmodul vermieden wird. In dem hier beschriebenen Beispiel ist das Funktionsmodul nicht direkt an dem Gehäuse befestigt, sondern bei unveränderter Lage mittels der Befestigungsmittel mit dem Boden des Gehäuses verbunden.

Vorteilhaft ist dabei, dass die Befestigungsmittel (11) und das Gehäuse (10) einen im Wesentlichen ringförmigen, freien Raum begrenzen. Durch die allseitige Entkopplung des Funktionsmoduls von den Seitenwänden des Gehäuses wird das Funktionsmodul besonders gut von Kraftwirkungen, die durch Verformungen des Gehäuses hervorgerufen werden, entkoppelt.

Eine vorteilhafte Ausgestaltung des Bauelements beinhaltet, dass die Befestigungsmittel mittels einer formschlüssigen Verbindung am Gehäuse oder am Funktionsmodul oder beiden befestigt sind. Gehäuse, Befestigungsmittel und Funktionsmodul werden dabei z.B. ineinander gesteckt. Die Befestigung erfolgt dabei durch Einrasten von komplementär geformten Elementen ineinander, z.B. Rastnasen in Nuten. Eine derartige Verbindungstechnik ist schnell in der Durchführung und kostengünstig im Vergleich zu Verbindungen durch Kleben, Schweißen, oder dergleichen. Alternativ kann die formschlüssige Befestigung auch zusammen mit einer anderen Befestigungsart verwendet werden. So kann z.B. das Befestigungsmittel vor oder während eines Klebevorganges in das Gehäuse eingesteckt werden. Durch diese Verbindungstechnik wird das Befestigungsmittel bis zur vollen Belastbarkeit der Klebeverbindung in seiner Position fixiert.

Eine weitere vorteilhafte Ausgestaltung des Bauelements besteht darin, dass die Befestigungsmittel und das Gehäuse aus einem Stück gefertigt sind. Dieser Aufbau macht eine Verbindung des Befestigungsmittels mit dem Gehäuse überflüssig und stellt daher eine kostengünstige Lösung dar.

Vorteilhaft ist weiterhin, dass die Befestigungsmittel mittels einer stoffschlüssigen Verbindung, insbesondere einer Schmelzverbindung, am Gehäuse oder am Funktionsmodul oder beiden befestigt sind. Eine stoffschlüssige Verbindung ist besonders fest und dauerhaft. Sie bietet daneben die Möglichkeit z.B. unterschiedliche Funktionsmodule mittels unterschiedlicher Befestigungsmittel in jeweils dem gleichen Gehäuse zu befestigen.

Eine weitere vorteilhafte Ausgestaltung des Bauelements beinhaltet, dass die Befestigungsmittel mittels einer Klebeverbindung, welche insbesondere definierte Klebeflächen aufweist, am Gehäuse oder am Funktionsmodul oder beiden befestigt sind. Klebeverbindungen lassen sich einfach und kostengünstig durchführen. Durch Wahl eines geeigneten flexiblen oder verformbaren Klebers für die Verbindung vom Gehäuse zum Befestigungsmittel oder auch vom Befestigungsmittel zum Funktionsmodul lässt sich die kraftentkoppelnde Wirkung des Befestigungsmittels unterstützen und noch verbessern.

Eine besonders vorteilhafte Ausgestaltung des Bauelementes besteht darin, dass die Befestigungsmittel zur Befestigung des Funktionsmoduls durch einen Modulhalterahmen dargestellt sind. Der Modulhalterahmen stellt einerseits ein Befestigungsmittel mit kraftentkoppelnder Wirkung dar. Der Modulhalterahmen weist einen im Wesentlichen geschlossenen, umlaufenden Rand auf, an dem das Funktionsmodul beliebig befestigt werden kann. Andererseits bietet er einen freien Raum im Inneren, der vom Funktionsmodul eingenommen werden kann. Somit wird der Innenraum des Gehäuses effektiv ausgenutzt.

Vorteilhaft ist weiterhin, dass der Modulhalterahmen wenigstens eine Seitenwand aufweist, welche einen Versatz aufweist. Der Versatz liegt vorzugsweise in der Erstreckungsrichtung der Seitenwand vom Boden des Gehäuses zum oberen Rand des Modulhalterahmens. Der Versatz kann ungefähr eine Wandstärke oder auch mehr betragen. Der Versatz trägt zur Kraftentkopplung des Funktionsmoduls vom Gehäuse bei.

Vorteilhaft ist auch, dass der Modulhalterahmen eine im Wesentlichen eckige Form aufweist. In einem eckigen Gehäuse wird der zur Verfügung stehende Raum durch eine derartige Formgebung am effektivsten genutzt. Das Funktionsmodul wird vorteilhaft an definierten Flächen des Modulhalterahmens befestigt. Insbesondere werden die Ecken des Rahmens bei der Befestigung des Funktionsmoduls ausgespart, um nachteilige Kraftwirkungen auf das Funktionsmodul weiter zu reduzieren.

Eine vorteilhafte Ausgestaltung sieht vor, dass der Modulhalterahmen an einer Seitenwand eine Ausformung derart aufweist, dass durch diese Ausformung ein Mindestabstand zwischen der besagten Seitenwand und einer Wand des Gehäuses definiert ist. Durch diesen Abstand zwischen Modulhalterahmen und Gehäuse kann z.B. der oben erwähnte ringförmige freie Raum dargestellt werden. Das Funktionsmodul wird insbesondere von Kraftwirkungen durch seitlichen Druck vom Gehäuse entkoppelt.

Vorteilhaft ist, dass das Funktionsmodul mikroelektroinechanische Strukturen beinhaltet. Mikroelektromechanischen Bauelementen nutzt eine Befestigung, die weitgehend von deformierenden Kraftwirkungen entkoppelt ist, in besonderer Weise, weil ihre mechanische Funktion in besonderer Weise von Verspannungen der Struktur beeinflusst und beeinträchtigt wird.

Vorteilhaft ist, dass es sich bei dem Bauelement um einen mikromechanischen Sensor, insbesondere um einen Beschleunigungssensor oder Drehratensensor, handelt. Die Genauigkeit dieser Sensoren hängt entscheidend von ihrer Befestigung frei von mechanischen Spannungen ab. Bei kraftentkoppelter Befestigung wird der Fehler des Ausgangssignals stark reduziert, sodass Kompensationsschaltungen einfacher gestaltet oder sogar ganz weggelassen werden können, Dadurch wird die Empfindlichkeit und die Genauigkeit des Sensors verbessert.

Ein vorteilhaftes Verfahren zur Montage eines Bauelements nach Anspruch 1, wobei das Gehäuse und das Befestigungsmittel mittels Kleber miteinander verbunden werden, sieht vor, dass wenigstens das Befestigungsmittel auf einer Seite eine Zugangsöffnung aufweist, durch welche hindurch der Klebstoff den Klebeflächen auf der anderen Seite des Befestigungsmittel zugeführt wird. Vorteilhaft ist hierbei, dass der Kleber von einer zugänglichen Seite einer möglicherweise unzugänglichen Seite, welche die Klebefläche bilden soll, zugeführt werden kann. Dies ist auch von Vorteil, wenn vor der Verbindung durch Verkleben die beiden Vorrichtungsteile bereits in die Position zueinander gebracht werden, die sie nach erfolgter Klebung einnehmen sollen.

Eine vorteilhafte Ausgestaltung des Verfahrens liegt darin, dass die Klebefläche durch eine, insbesondere geschlossene und die Klebefläche umgreifende Ausnehmung, an wenigstens einem Vorrichtungsteil begrenzt wird. Der Klebstoff breitet sich von der Zugangsöffnung ausgehend aus. Durch verschiedene Einflüsse wie z.B. Abstand der Vorrichtungsteile zueinander, Oberflächenbeschaffenheit, Inhomogenität des Klebstoffes und weitere kann es dazu kommen, dass der Kleber sich, von der Zugangsöffnung ausgehend, nicht in alle Richtungen gleichermaßen auf der Klebefläche verteilt. Weiterhin ist es auch möglich, dass die Zugangsöffnung nicht zentral auf der Klebefläche angeordnet ist.

Trotzdem soll die Klebefläche eine bestimmte Form aufweisen, um gewisse Eigenschaften der Verbindung und der verbundenen Vorrichtungsteile zu gewährleisten. Die die Klebefläche zumindest teilweise begrenzende oder ganz umschließende Ausnehmung an zumindest einem Vorrichtungsteil bewirkt, dass die Ausbreitung des Klebstoffes auf der Klebefläche an eben jener Ausnehmung begrenzt oder zumindest behindert wird. Dadurch wird eine bestimmte Form der Klebefläche definiert.

Eine weitere vorteilhafte Ausgestaltung des Verfahrens liegt darin, dass die Zugangsöffnung in Form eines Klebeschachtes ausgebildet ist, welcher ein Volumen aufweist, und dass die für die Klebeverbindung verwendete Klebermenge in dieses Volumen eingefüllt wird. Auf diese Weise kann einfach die für die Klebeverbindung benötigte Menge Klebstoff in den Schacht eingefüllt werden. Der Klebstoff gelangt anschließend durch die Zugangsöffnung auf die Klebefläche.

Eine weitere vorteilhafte Ausgestaltung des Verfahrens liegt darin, dass die Zugangsöffnung in Form eines Klebeschachtes derart ausgebildet ist, dass eine Druckleitung daran angeschlossen werden kann, durch welche der Klebstoff zugeführt wird. Auf diese Weise kann der Klebstoff mit kontrollierter Geschwindigkeit und Dosiermenge durch die Zugangsöffnung auf die Klebefläche transportiert werden. Die Geschwindigkeit des Klebstofftransportes wird in hohem Maße durch den Druck bestimmt, mit dem der Klebstoff in den Klebeschacht gepresst wird. Weiterhin kann durch ein Massenfluss Kontrollsystem oder anders geeignet gesteuerte Ventile in der Druckleitung die Klebstoffmenge genau dosiert werden.

Eine weitere vorteilhafte Ausgestaltung des Verfahrens liegt darin, dass das Gehäuse und das Befestigungsmittel vor oder während der Verbindung durch Kleben durch ein weiteres Verbindungsverfahren, insbesondere eine formschlüssige Verbindung, aneinander befestigt werden. Durch eine formschlüssige Verbindung, z.B. Einrasten der beiden Teile ineinander können Gehäuse und Befestigungsmittel in ihrer Position zueinander fixiert werden. So kann unter anderem der Abstand dieser beiden Teile zueinander an der Klebefläche bestimmt werden. Weiterhin werden die Teile durch die formschlüssige Verbindung während des Verfahrensschrittes festgehalten, in dem der Kleber durch Einpressen oder selbsttätiges Verfließen die Klebeflächen benetzt und schließlich durch Aushärten die volle Festigkeit der Verbindung gewährleistet.

Weitere vorteilhafte Ausgestaltungen sind den Unteransprüchen zu entnehmen.

### Zeichnung

Ausführungsbeispiele der Erfindung sind in der Zeichnung dargestellt und in der nachfolgenden Beschreibung näher erläutert.
Fig. 1 zeigt die Explosionsdarstellung eines erfindungsgemäßen Bauelements.
Fig. 2 zeigt die Schnittdarstellung eines erfindungsgemäßen Bauelements.
Fig. 3 stellt eine Ausführung des Befestigungsmittels in Form eines Modulhalterahmens in verschiedenen Ansichten dar.
Fig. 4 zeigt das Verkleben des Modulhalterahmens mit dem Gehäuse an definierten Flächen.
   In Fig. 4A ist ein zum Verkleben besonders geeigneter Modulhalterahmen dargestellt.
   In Fig. 4B ist das Aufbringen von Kleber auf eine definierte Klebefläche dargestellt.
   In Fig. 4C ist eine vollständig ausgeführte Klebeverbindung zwischen Modulhalterahmen und Gehäuse dargestellt.
Fig. 5 zeigt das Aufbringen von Kleber auf eine definierte Klebefläche 44 unter Druck.

### Beschreibung von Ausführungsbeispielen

Anhand der im folgenden beschriebenen Ausführungsformen soll die Erfindung detailliert dargestellt werden.

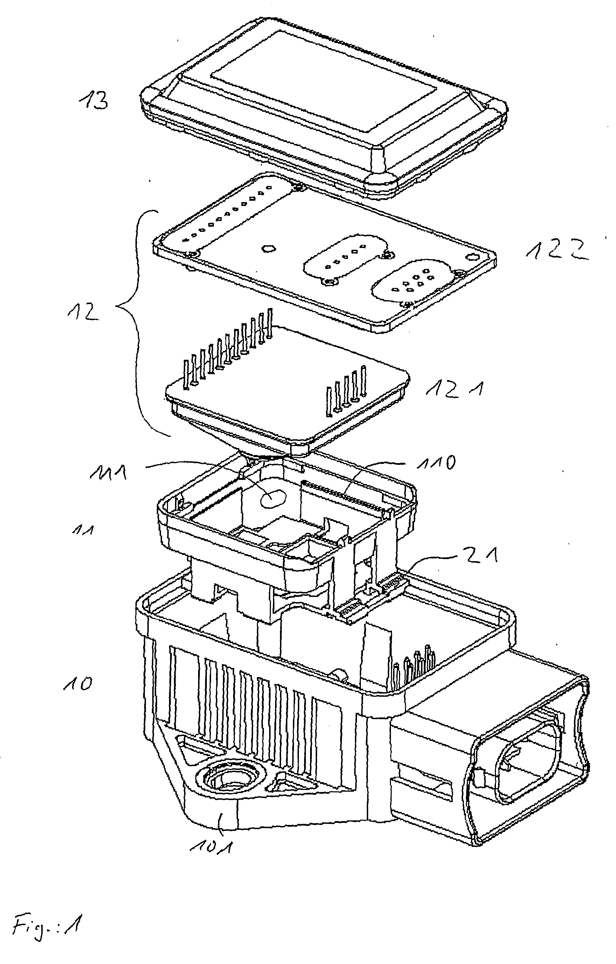

Fig. 1 zeigt die Explosionsdarstellung eines erfindungsgemäßen Bauelements. Das Bauelement besteht aus einem Gehäuse 10, einem Befestigungsmittel in Form eines Modulhalterahmens 11, einem Funktionsmodul 12 und einem Gehäusedeckel 13. Das Gehäuse 10 weist Laschen 101 auf, mittels derer es mit einer Fahrzeugkarosserie verschraubt werden kann. Das Gehäuse 10 besitzt in diesem Beispiel eine im Wesentlichen quaderförmige Gestalt. Der Modulhalterahmen 11 besitzt definierte Flächen 110 zur Befestigung des Funktionsmoduls 12, die als Auflageflächen 110 ausgebildet sind. Die Ecken 111 sind dabei ausgespart. Die Befestigung des Funktionsmoduls 12 an den Auflageflächen 110 erfolgt z.B. durch eine Klebeverbindung. Die Auflageflächen 110 können aber auch zur bloßen Auflage des Funktionsmoduls 12 auf dem Modulhalterahmen 11 dienen, und das Funktionsmodul 12 ist an dem Modulhalterahmen 11 mittels einer anderen Befestigung, wie z.B. Schweißen am Rand, oder dergleichen verbunden. Das Funktionsmodul 12 besteht aus einem Funktionselement 121 und einer, insbesondere mit einer elektronischen Schaltung versehenden, Grundplatte 122, die miteinander verbunden und in diesem Beispiel elektrisch kontaktiert sind.

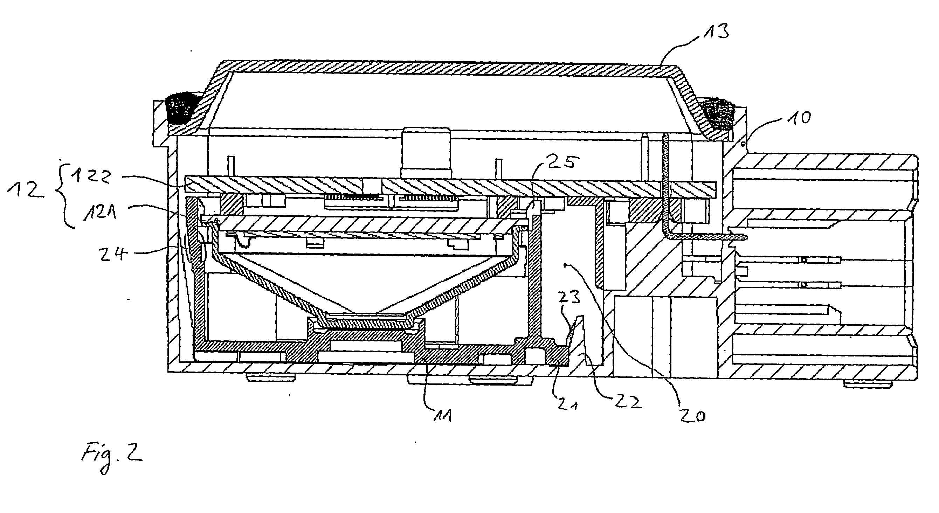

Fig. 2 zeigt die Schnittdarstellung eines erfindungsgemäßen Bauelements. Gehäuse 10 und Modulhalterahmen 11 begrenzen einen im Wesentlichen ringförmigen, freien Raum 20.

In gebräuchliche Ausführungen von Bauelementen nach Stand der Technik ist die Grundplatte 122 des Funktionsmoduls 12 oftmals direkt mit dem Gehäuse 10 verbunden. Das Funktionsmodul ist z.B. mit dem Rand des Gehäuses 10 verklebt. Durch diesen Aufbau werden Verformungen des Gehäuses, insbesondere Druckspannung, Zugspannung oder Torsion des Gehäuserandes, direkt auf das Funktionsmodul 12 übertragen. Das erfindungsgemäße Bauelement beinhaltet im Prinzip ein Gehäuse im Gehäuse. Am Boden des Gehäuses 10 ist ein weiteres Gehäuse befestigt, nämlich der Modulhalterahmen 11. Am oder in der Nähe des oberen Randes des Modulhalterahmens 11 ist das Funktionsmodul 12 befestigt. Bei Verformungen des äußeren Gehäuses 10 auftretende Kräfte können nicht mehr direkt auf das Funktionsmodul übertragen werden. Diese Kräfte müssen über die Seitenwände in den Boden des Gehäuses 10 eingeleitet und dann auf den Boden des Modulhalterahmens 11 übertragen werden. Im Modulhalterahmen 11 müssen die Kräfte in die Seitenwände weitergeleitet werden, bevor sie am Funktionsmodul 12 angreifen können. Gegenüber dem Aufbau nach Stand der Technik stellt der erfindungsgemäße Aufbau des Bauelements eine Wegverlängerüng für Kräfte dar. Durch die mögliche Verformung des Gehäuses 10 und zusätzlich des Modulhalterahmens 11 vermindern sich die Kräfte. Es erfolgt also eine zumindest teilweise Entkopplung des Funktionsmoduls 12 von Kräften die aus Verformungen des Gehäuses 10 resultieren.

Der Modulhalterahmen 11 weist eine Seitenwand mit einem Versatz 24 auf, der in diesem Beispiel ca. eine Wanddicke beträgt. Es ist jedoch auch ein größerer oder kleinerer Versatz 24 denkbar. Weiterhin besitzt der Modulhalterahmen 11 eine Ausformung 21, eine sogenannte Auflagebrücke, die einen Mindestabstand des Modulhalterahmens 11 zur angrenzenden Wand des Gehäuses 10 definiert und damit auch die Weite des freien Raumes 20 bestimmt. In dem hier gezeigten Beispiel grenzt der Modulhalterahmen 11 nicht direkt an eine Seitenwand des Gehäuses 10, sondern die Auflagebrücke 21 liegt an einer Gehäuseausformung 22 an. An der Gehäuseausformung 22 befindet sich eine weitere Ausformung 23 die eine formschlüssige Befestigung des Modulhalterahmens 11 am Gehäuse 10, z.B. durch Einrasten ermöglicht. Weiterhin besitzt der Modulhalterahmen 11 Ausformungen 25, welche eine formschlüssigen Verbindung des Funktionsmoduls 12 mit dem Modulhalterahmen 11 ermöglichen. Das Funktionsmodul 12 wird dazu in den Modulhalterahmen 11 eingerastet.

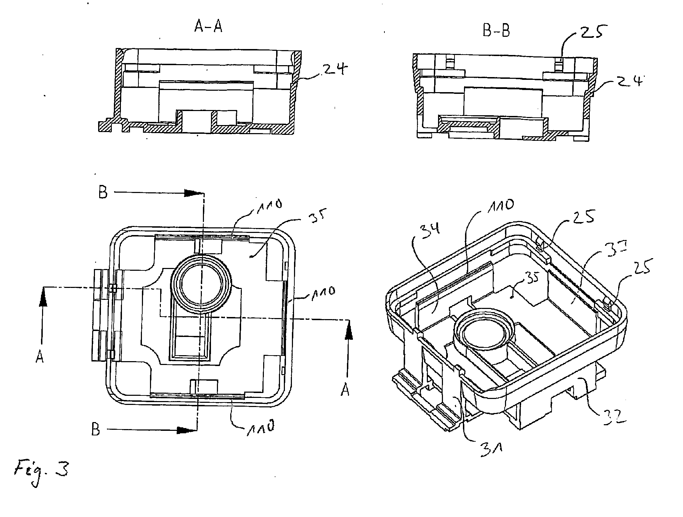

Fig. 3 stellt eine Ausführung des Befestigungsmittels in Form eines Modulhalterahmens 11 in verschiedenen Ansichten dar. Es sind Darstellungen in den Schnitten A-A und B-B, eine Draufsicht, sowie eine perspektivische Ansicht gezeigt. Die Draufsicht zeigt die Auflageflächen 110. Die perspektivische Ansicht zeigt eine Auflagefläche 110 und Ausformungen 25 für eine formschlüssige Verbindung zwischen Modulhalterahmen 11 und Funktionsmodul 12. Weiterhin ist erkennbar, dass die Seitenwände 31, 32, 33 und 34 nur teilweise ausgeführt sind, insbesondere unter Aussparung der Ecken. Die Seitenwände schließen daher auch nicht aneinander an. Der Boden besitzt ebenfalls Ausnehmungen, wodurch die Ecken des Modulhalterahmens 11 ausgespart sind.

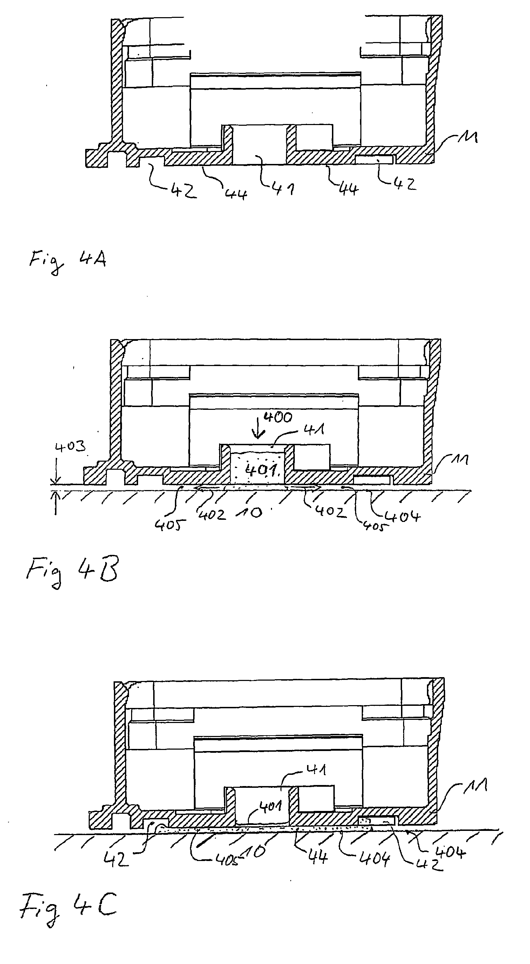

Fig. 4 zeigt das Verkleben des Modulhalterahmens 11 mit dem Gehäuse 10 an definierten Flächen.

In Fig. 4A ist ein zum Verkleben besonders geeigneter Modulhalterahmen 11 dargestellt. Zum Befestigen mittels Verkleben weist der Modulhalterahmen 11 einen Zugang im Boden, einen sogenannten Klebeschacht 41 auf, welcher insbesondere derart ausgestaltet ist, dass er ein bestimmtes Volumen V umfasst. Angrenzend an den Klebeschacht 41 erstreckt sich die Klebefläche 44, welche von einer umlaufenden, geschlossenen Ausnehmung 42 begrenzt wird.

In Fig. 4B ist das Aufbringen von Kleber auf eine definierte Klebefläche 44 dargestellt. Zuerst wird der Modulhalterahmen 11 in das Gehäuse 10 eingesetzt. Der Modulhalterahmen 11 weist hierbei einen Abstand 403 zum Boden des Gehäuses 10 auf, welcher in der Fig. 4B überhöht dargestellt ist. Anschließend wird eine, insbesondere durch das Volumen V_{K} des Klebeschachtes 41 bestimmte, definierte Menge Klebstoff 401 in Richtung 400 in den Klebeschacht eingebracht. Der Klebstoff 401 verfließt vom Klebeschacht 41 aus in alle Richtungen 402 parallel zum Boden des Gehäuses 10 und nimmt dabei den vormals freien Raum 405 ein, der im Wesentlichen durch die Flächen 44 und die Oberfläche 404 des Bodens des Gehäuses 10 im Abstand 403 begrenzt wird.

In Fig. 4C ist eine vollständig ausgeführte Klebeverbindung zwischen Modulhalterahmen 11 und Gehäuse 10 dargestellt. Der Klebeschacht 41 ist im Wesentlichen leergelaufen und enthält eventuell noch Reste des Klebers 401. Der Kleber 401 füllt nunmehr ein Volumen V_{R} des Raumes 405 aus, welches im Wesentlichen dem Volumen V_{K} des vormals gefüllten Klebeschachtes 41 entspricht. Der Kleber 401 benetzt die Klebefläche 44 des Modulhalterahmens 11 und die gegenüberliegende Oberfläche 405 des Gehäuses 10. Der Fluss des Klebers 401 in die Richtungen 402 wird bei Erreichen der Ausnehmung 42 stark verlangsamt, weil das zu verfüllende Volumen bezogen auf die zurückgelegte Wegstrecke in Richtung 402 sich stark erhöht. Bis zur vollständigen Verteilung des Klebers 401 und seines Aushärtens oder Abbindens wird erfindungsgemäß die umlaufende Ausnehmung 42 nur teilweise verfüllt. Im Ergebnis entsteht eine Verbindung zwischen Modulhalterahmen 11 und Gehäuse 10 an einer definierten Fläche, welche im Wesentlichen durch die Klebefläche 44 dargestellt ist und die durch den Klebeschacht 41 und die umlaufende Ausnehmung 42 begrenzt ist.

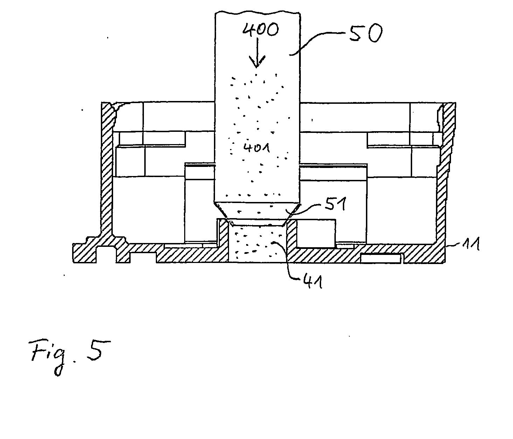

Fig. 5 zeigt das Aufbringen von Kleber auf eine definierte Klebefläche 44 unter Druck. Alternativ zu dem in den Fig. 4A und 4B beschriebenen Verfahren ist es auch möglich, den Klebeschacht 41 derart zu gestalten, dass er nicht notwendigerweise das Volumen der benötigten Klebermenge 401 umfasst, sondern zur Aufnahme oder zum Anschluss einer Druckleitung 50, insbesondere mit einer an deren Ende befindlichen Düse 51 geeignet ist. Angrenzend an den Klebeschacht 41 erstreckt sich die Klebefläche 44, welche von einer umlaufenden, geschlossenen Ausnehmung 42 begrenzt wird. Zunächst wird der Modulhalterahmen 11 in das Gehäuse 10 eingesetzt. Der Modulhalterahmen 11 weist hierbei einen Abstand 403 zum Boden des Gehäuses 10 auf. Danach wird die Druckleitung 50 an den Klebeschacht 41 angeschlossen, indem z.B. wie in diesem Beispiel gezeigt, eine Düse 51 in den Klebeschacht 41 eingesetzt wird. Schließlich wird eine bestimmte Menge Klebstoff 401 unter Druck in den Raum 405 eingepresst. Dabei füllt der Kleber 401 das Volumen V_{R} des Raumes 405 aus. Je nach Viskosität des Klebers, Abstand 403 von Gehäuse 10 und Modulrahmen 11 zueinander und der angestrebten Geschwindigkeit des Klebeverfahrens kann der Druck mit dem der Kleber 401 in den Klebeschacht 41 eingepresst wird sehr niedrig, d.h. bis zu einer Druckdifferenz zur Umgebung nahe Null oder hoch, z.B. bis zu mehreren bar gewählt werden. Nach dem Einfüllen der gewünschten Klebstoffmenge wird die Düse 51 aus dem Klebeschacht 41 entfernt. Der Klebeschacht 41 kann bei vollständig ausgeführter und Ausgehärteter Klebeverbindung immer noch wenigstens teilweise mit Klebstoff 401 gefüllt sein.

## Patentansprüche

1. Bauelement mit einem Gehäuse (10), einem beinhalteten Befestigungsmittel in Form eines Modulhalterahmens (11), einem Funktionsmodul (12) und einem Gehäusedeckel (130), wobei das Funktionsmodul (12) von Kraftwirkungen, die durch Verformungen des Gehäuses (10) hervorgerufen werden, zumindest teilweise entkoppelt ist, **dadurch gekennzeichnet, dass** das Funktionsmodul (12) am oder in der Nähe des oberen Randes des Modulhalterahmens (11)befestigt ist, und dass der Modulhalterahmen (11) am Boden des Gehäuses (10) mittels Kleber (401) befestigt ist, wobei der Boden des Modulhalterahmens (11) auf einer Seite eine Zugangsöffnung (41) aufweist, durch welche hindurch der Klebstoff (401) den Klebeflächen (44, 404) auf einer anderen Seite des Modulhalterahmens (11) zugeführt ist.

2. Bauelement nach Anspruch 1, **dadurch gekennzeichnet, dass** der Modulhalterahmen (11) wenigstens eine Seitenwand aufweist, welche einen Versatz (24) aufweist.

3. Bauelement nach Anspruch 1, **dadurch gekennzeichnet, dass** der Modulhalterahmen (11) eine im Wesentlichen eckige Form aufweist und definierte Flächen (110), insbesondere unter Aussparung der Ecken (111), zur Befestigung des Funktionsmoduls (12) aufweist.

4. Bauelement nach Anspruch 1, **dadurch gekennzeichnet, dass** der Modulhalterahmen (11) mindestens an einer Wand wenigstens eine Ausformung (21) derart aufweist, dass die Ausformung (21) einen Mindestabstand zwischen dieser Wand des Modulhalterahmens (11) und einer Wand des Gehäuses (10) definiert.

5. Bauelement nach Anspruch 1, **dadurch gekennzeichnet, dass** das Funktionsmodul (12) mikroelektromechanische Strukturen beinhaltet.

6. Bauelement nach Anspruch 1, **dadurch gekennzeichnet, dass** es sich bei dem Bauelement um einen mikromechanischen Sensor, insbesondere um einen Beschleunigungssensor oder Drehratensensor, handelt.

7. Verfahren zur Montage eines Bauelements nach Anspruch 1, wobei das Gehäuse (10) und der Modulhalterahmen (11) mittels Kleber (401) miteinander verbunden werden,
**dadurch gekennzeichnet, dass**
wenigstens der Modulhalterahmen (11) auf einer Seite eine Zugangsöffnung (41) aufweist, durch welche hindurch der Klebstoff (401) den Klebeflächen (44, 404) auf einer anderen Seite des Modulhalterahmens 11) zugeführt wird.

8. Verfahren nach Anspruch 7, **dadurch gekennzeichnet, dass** die Klebefläche (44) durch eine, insbesondere geschlossene und die Klebefläche (44) umgreifende Ausnehmung (42), an wenigstens dem Modulhalterahmen (11) begrenzt wird.

9. Verfahren nach Anspruch 7, **dadurch gekennzeichnet, dass** die Zugangsöffnung (41) in Form eines Klebeschachtes (41) ausgebildet ist, welcher ein Volumen aufweist, und dass die für die Klebeverbindung verwendete Klebermenge in dieses Volumen eingefüllt wird.

10. Verfahren nach Anspruch 7, **dadurch gekennzeichnet, dass** die Zugangsöffnung (41) in Form eines Klebeschachtes (41) derart ausgebildet ist, dass eine Druckleitung (50) daran angeschlossen werden kann, durch welche der Klebstoff (401) zugeführt wird.

11. Verfahren nach Anspruch 7, **dadurch gekennzeichnet, dass** das Gehäuse (10) und das Befestigungsmittel (11) vor oder während der Verbindung durch Kleben durch ein weiteres Verbindungsverfahren, insbesondere eine formschlüssige Verbindung, aneinander befestigt werden.

## Claims

1. Component having a housing (10), having a comprised fastening means in the form of a module holding frame (11), having a functional module (12) and having a housing cover (130), with the functional module (12) being at least partially decoupled from force actions which are caused by deformations of the housing (10), **characterized in that** the functional module (12) is fastened to the module holding frame (11) at or in the vicinity of the upper edge of the latter, and **in that** the module holding frame (11) is fastened to the base of the housing (10) by means of adhesive (401), with the base of the module holding frame (11) having, on one side, an access opening (41) through which the adhesive (401) is supplied to the adhesion surfaces (44, 404) on another side of the module holding frame (11).

2. Component according to Claim 1, **characterized in that** the module holding frame (11) has at least one side wall which has an offset (24).

3. Component according to Claim 1, **characterized in that** the module holding frame (11) has a substantially angular shape and defined faces (110), in particular with cutting-out of the corners (111), for fastening the functional module (12).

4. Component according to Claim 1, **characterized in that** the module holding frame (11) has, at least on one wall, at least one shaped-out portion (21), in such a way that the shaped-out portion (21) defines a minimum spacing between said wall of the module holding frame (11) and a wall of the housing (10).

5. Component according to Claim 1, **characterized in that** the functional module (12) contains microelectromechanical structures.

6. Component according to Claim 1, **characterized in that** the component is a micromechanical sensor, in particular an acceleration sensor or rotational velocity sensor.

7. Method for assembling a component according to Claim 1, with the housing (10) and the module holding frame (11) being connected to one another by means of adhesive (401),
**characterized in that**
at least the module holding frame (11) has, on one side, an access opening (41) through which the adhesive (401) is supplied to the adhesion surfaces (44, 404) on another side of the module holding frame (11).

8. Method according to Claim 7, **characterized in that** the adhesion surface (44) is delimited by a recess (42), which is in particular closed and engages around the adhesion surface (44), on at least the module holding frame (11).

9. Method according to Claim 7, **characterized in that** the access opening (41) is designed in the form of an adhesive slot (41) which has a volume, and **in that** the adhesive quantity used for the adhesive connection is filled into said volume.

10. Method according to Claim 7, **characterized in that** the access opening (41) is designed in the form of an adhesive slot (41) in such a way that a pressure line (50) can be connected thereto, through which pressure line (50) the adhesive (401) is supplied.

11. Method according to Claim 7, **characterized in that** the housing (10) and the fastening means (11) are fastened to one another, before or during the connection by means of adhesive, by means of a further connecting method, in particular a form-fitting connection.

## Revendications

1. Composant comprenant un boîtier (10), un moyen de fixation contenu dans celui-ci, sous la forme d'un cadre de fixation de module (11), un module fonctionnel (12) et un couvercle de boîtier (130),
le module fonctionnel (12) étant au moins en partie découplé des effets des forces engendrées par les déformations du boîtier (10),
**caractérisé en ce que**
le module fonctionnel (12) est fixé au bord supérieur du cadre de fixation du module (11) ou à proximité de celui-ci et
le cadre de fixation de module (11) est fixé au fond du boîtier (10) par de la colle (401),
le fond du cadre de fixation de module (11) présente sur un côté un orifice d'accès (41) par lequel on applique la colle (401) aux surfaces de collage (44, 404), de l'autre côté du cadre de fixation de module (11).

2. Composant selon la revendication 1,
**caractérisé en ce que**
le cadre de fixation de module (11) a au moins une paroi latérale avec un décalage (24).

3. Composant selon la revendication 1,
**caractérisé en ce que**
le cadre de fixation de module (11) a une forme pratiquement polygonale et une surface définie (110) notamment en dégageant les coins (111) pour fixer le module fonctionnel (12).

4. Composant selon la revendication 1,
**caractérisé en ce que**
le cadre de fixation de module (11) présente une déformation (21) sur au moins une paroi de façon que cette déformation (21) définisse une distance minimale entre cette paroi du cadre de fixation de module (11) et une paroi du boîtier (10).

5. Composant selon la revendication 1,
**caractérisé en ce que**
le module fonctionnel (12) contient des structures de microélectronique.

6. Composant selon la revendication 1,
**caractérisé en ce qu'**
il constitue un capteur micromécanique notamment un capteur d'accélération, un capteur de vitesse de rotation.

7. Procédé de montage d'un composant selon la revendication 1 dont le boîtier (10) et le cadre de fixation de module (11) sont reliés par une colle (401),
**caractérisé en ce qu'**
au moins le cadre de fixation de module (11) présente d'un côté un orifice d'accès (41) à travers lequel on applique de la colle (401) aux surfaces de collage (44, 404) de l'autre côté du cadre de fixation de module (11).

8. Procédé selon la revendication 7,
**caractérisé en ce que**
la surface de collage (44) est délimitée par une cavité (42) notamment fermée et entourant la surface de collage (44) au moins sur le cadre de fixation de module (11).

9. Procédé selon la revendication 7,
**caractérisé en ce que**
l'orifice d'accès (41) est réalisé sous la forme d'un puits de colle (41) ayant un certain volume et la quantité de colle utilisée pour la liaison collée est chargée dans ce volume.

10. Procédé selon la revendication 7,
**caractérisé en ce que**
l'orifice d'accès (41) est réalisé sous la forme d'un puits de colle (41) auquel est raccordée une conduite de pression (50) pour fournir la colle (401).

11. Procédé selon la revendication 7,
**caractérisé en ce que**
le boîtier (10) et le moyen de fixation (11) sont fixés l'un à l'autre avant et pendant la liaison par la colle à l'aide d'un autre procédé de liaison notamment par une liaison par la forme.
